Europäisches Patentamt

European Patent Office

Office européen des brevets

(11) Publication number : **0 518 532 A1**

# (12) EUROPEAN PATENT APPLICATION

(21) Application number : **92304927.4**

(22) Date of filing : **29.05.92**

(51) Int. Cl.⁵ : **C23C 16/26, H01H 1/02**

(30) Priority : **29.05.91 GB 9111474**

(43) Date of publication of application :
**16.12.92 Bulletin 92/51**

(84) Designated Contracting States :
**AT BE CH DE FR GB IT LI NL SE**

(71) Applicant : **DE BEERS INDUSTRIAL DIAMOND
DIVISION (PROPRIETARY) LIMITED
Debid House, Corner Amethyst Street &
Crownwood Road, Theta
Johannesburg, Transvaal (ZA)**

(72) Inventor : **JONES, Barbara Lyn
80 Chisbury Close, Forest Park
Bracknell, RG12 3TX (GB)**

(74) Representative : **Ellis-Jones, Patrick George
Armine
J.A. KEMP & CO. 14 South Square Gray's Inn
London WC1R 5LX (GB)**

(54) **Boron-doped diamond.**

(57) cvd diamond which is boron doped and has a boron concentration in the range 1000 to 4500ppm. The boron concentration is preferably 1800ppm.

EP 0 518 532 A1

## BACKGROUND OF THE INVENTION

This invention relates to boron-doped diamond.

Diamonds have been produced synthetically for the past 30 or so years by subjecting a carbon source such as graphite to a pressure exceeding 50 kilobars and a temperature exceeding 1200°C in the presence of a catalyst metal such as nickel, cobalt or iron. Diamonds produced synthetically in this manner can be tailored to a variety of shapes and forms. It is also possible to produce large diamonds by this method. However, such diamonds, although of good quality, will invariably contain metal inclusions.

It is also possible to synthesise diamond from the gas phase. This method is known as chemical vapour deposition (CVD) and the diamond produced is known as CVD diamond. The process generally involves providing a mixture of hydrogen gas and a suitable gaseous carbon compound such as a hydrocarbon, applying sufficient energy to that gas to dissociate the hydrogen into atomic hydrogen and the gas into active carbon ions, atoms or CH radicals and allowing such active species to deposit on a substrate to form diamond. Dissociation of the gases can take place by a variety of methods.

One such method is the use of a hot filament. In this method, the gas temperature at the filament is about 2000°C and the substrate on which diamond growth occurs is at 800 to 1100°C.

A second commonly used method is a plasma assisted method. The hydrogen and gaseous carbon compound enter a plasma region, which may be microwave, RF or DC plasma, where they are excited to their reactive states. They diffuse in this state to a substrate. The substrate is heated by the plasma.

Yet a further method of exciting the hydrogen/gaseous carbon compound mixture is with the use of a plasma jet. One such method is described in EP 0286306 which involves effecting an arc discharge while feeding a discharge gas between an anode and a cathode of a thermal plasma chemical vapour deposition device, activating or producing radicals from a gaseous carbon compound by feeding the gaseous compound to a generated plasma jet and permitting the plasma jet containing the radicals to impinge on a substrate thereby to form diamond on the substrate.

## SUMMARY OF THE INVENTION

It has been found that boron-doped CVD diamond which has a high concentration of boron has a resistivity which is sharply lower than a corresponding boron-doped synthetic diamond crystal produced using high temperature/high pressure technology. Thus, the invention provides, according to one aspect, CVD diamond which is highly boron-doped, particularly having a boron concentration in the range 1000 to 4500ppm.

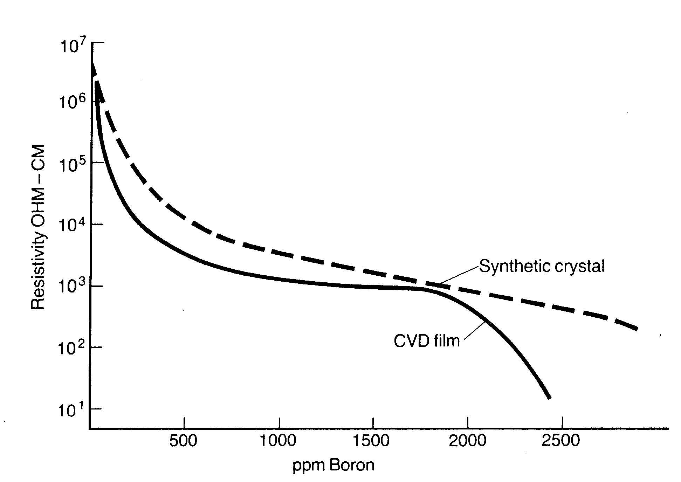

## DESCRIPTION OF THE DRAWING

The drawing illustrates graphically the resistivity in ohms⁻ᶜᵐ against ppm boron for a synthetic crystal and a CVD film.

## DESCRIPTION OF EMBODIMENTS

The surprising aspect of the present invention is that highly boron-doped CVD diamond has a resistivity much lower than a corresponding boron-doped synthetic diamond crystal produced by conventional high pressure/high temperature technology. This is illustrated graphically in the attached drawing. It will be noted that for boron concentrations of greater than about 1800ppm the resistivity of the CVD diamond film drops away sharply relative to the synthetic crystal.

It has also been found that the higher the boron content the more oxidation resistant the CVD diamond becomes.

The diamond may be in the form of a particle, a shaped product such as a cube, triangle or the like, a plate or a film. It may be produced using any of the known CVD methods described above. The inclusion of boron in the CVD diamond is achieved by ensuring that there is a presence of boron atoms in the gas or gaseous mixture. The higher the boron atom content in this gas or mixture, the higher the concentration of boron in the CVD diamond. One suitable CVD method is that using microwave energy to create plasma. Such a method was used to produce the CVD diamond film on which the resistivity measurements of the attached graph were made. The following conditions were employed to produce a boron content of 1800ppm:

| Pressure | 50 torr |
|---|---|
| Power | 200 watt |
| Substrate Temperature | 830°C |
| $H_2$ flow | 70 sccm |
| Methane flow | 1 sccm |
| Diborane/$H_2$ (30ppm $B_2H_6/H_2$) flow | about 40 sccm |

(sccm = standard cubic centimetres per minute)

By varying the concentration of diborane in the diborane/hydrogen flow, variations in the boron content of the CVD film was achieved.

The low resistivity of highly boron-doped CVD diamond may be used in a variety of applications. For example, it may be used in magnetic switches. Magnetic switches are typically made of metals such as copper which can weld together due to the high temperatures generated by such switches. One or both of the contacting surfaces of the opposed copper elements for such switches may be provided with a highly boron-doped diamond film which will prevent such welding taking place. Further, the CVD diamond film is abrasion resistant increasing the life of the switch.

A CVD diamond film or layer may also be used in a chemical sensor wherein the resistance of the sensor is constant in a given chemical environment. As rogue elements enter the environment a "load" resistance changes hence the "apparent resistance" of the sensor changes. The abrasion and corrosion resistance and low resistivity of the boron-doped CVD diamond makes this an excellent material for such applications.

The boron-doped CVD diamond may also be used as a protective film for probes and video heads which are subjected to abrasion and corrosion in humid and oxidising environments.

## Claims

1. CVD diamond which is boron doped and has a boron concentration in the range 1000 to 4500ppm.

2. CVD diamond according to claim 1 which has a boron concentration of at least 1800ppm.

3. A Magnetic switch in which at least one of the opposed metal switch surfaces is provided with a CVD diamond as claimed in claim 1 or 2.

4. A chemical sensor which comprises a film or layer of a CVD diamond as claimed in claim 1 or 2.

**European Patent Office**

# EUROPEAN SEARCH REPORT

Application Number

EP 92 30 4927

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-2 228 949 (KABUSHIKI KAISHAKOBE SEIKO SHO) <br> * page 2, line 16 - page 3, line 3; figure 7 * <br> --- | 1,2 | C23C 16/26 <br> H01H1/02 |
| X | JAPANESE JOURNAL OF APPLIED PHYSICS <br> vol. 28, no. 6, 1 June 1989, TOKYO JP <br> pages 1066 - 1071; <br> K. OKANO: 'CHARACTERIZATION OF BORON DOPED DIAMOND FILMS' | 1 | |
| Y | * page 1069, right column, line 7 - page 1070, left column, line 10; figure 8 * <br> --- | 4 | |
| Y | WORLD PATENTS INDEX LATEST <br> Derwent Publications Ltd., London, GB; <br> AN 90-370738 50! <br> & JP-A-2 266 253 (IDEMITSU PETROCHEM KK) 31 October 1990 <br> * abstract * <br> --- | 4 | |
| A | DE-B-2 360 485 (W.C. HERAEUS GMBH) <br> * column 2, line 28 - line 38 * <br> --- | 3 | |
| P,X | K.DAS ET AL. 'PROCEEDINGS OF THE FIRST INTERNATIONAL CONFERENCE ON THE APPLICATIONS OF DIAMOND FILMS AND RELATED MATERIALS' <br> 17 August 1991 , ELSEVIER , AMSTERDAM NL <br> * page 303, line 44 - page 304, line 8 * <br> ----- | 1,2 | TECHNICAL FIELDS SEARCHED (Int. Cl.5 ) <br><br> C23C <br> H01H |

The present search report has been drawn up for all claims

| Place of search | Date of completion of the search | Examiner |
|---|---|---|
| THE HAGUE | 17 SEPTEMBER 1992 | EKHULT H. U. |

EPO FORM 1503 03.82 (P0401)